# EUROPEAN PATENT APPLICATION

(11) **EP 4 580 336 A1**
(43) Date of publication of application: **02.07.2025**
(21) Application number: 24220194.5
(22) Date of filing: 16.12.2024
(51) Int. Cl.: H10D 30/01, H10D 30/00, H10D 64/23, B82Y 10/00

(54) **GAA FIELD-EFFECT TRANSISTORS WITH ASYMMETRIC BACKSIDE SOURCE AND TOPSIDE DRAIN CONTACTS**

(30) Priority: 29.12.2023 US 202318400193
(71) Applicant: Intel Corporation, Santa Clara, CA 95054 (US)
(72) Inventor: DEWEY, Gilbert, Beaverton, 97006 (US); KOBRINSKY, Mauro J., Portland, 97229 (US); GUDMUNDSSON, Valur, Austin, 78737 (US); D'SILVA, Joseph, Hillsboro, 97124 (US); MILLS, Shaun, Hillsboro, 97123 (US); ABD EL QADER, Makram, HILLSBORO, 97124 (US); MANNEBACH, Ehren, Beaverton, 97007 (US); NANDI, Debaleena, Hillsboro, 97124 (US)
(74) Representative: 2SPL Patentanwälte PartG mbB

(57) **Abstract**

Nanosheet GAA FETs with source and drain contacts that are not symmetric with respect to each other, and methods of forming the same, are disclosed herein. In one example, a semiconductor device includes a source (110), a drain (110), a back-side source contact (117), a top-side drain contact (117), a plurality of channels (108), and a gate (104). The source contact is coupled to the source and the drain contact is coupled to the drain, and the source and drain contacts are not symmetric with respect to each other, in that the source contact at the back-side is wider than the drain contact at the top-side. The contacts (117) may both be disposed in a recess in the respective source or drain region (110), and the recess may be coated with liners (116, 118).

## Description

### BACKGROUND

The source and drain regions of transistors include electrical contacts to enable electrical connections to be formed to and from the transistors. In general, larger contact sizes reduce resistance, which improves performance. If the source/drain contacts are too large, however, parasitic capacitance may increase. For example, as the size of the source/drain contacts increases, the distance between the trenches of the source/drain contacts and the gate contact decreases. If the source/drain contacts and the gate contact become too close to each other, parasitic capacitance increases, which may lead to a higher propensity for shorting, thus reducing process yield. Thus, while larger source/drain contacts reduce resistance, they can also increase parasitic capacitance if they become too large, which may negate the performance gains from lower resistance.

### BRIEF DESCRIPTION OF THE DRAWINGS

**FIG. 1** illustrates an example of a transistor with asymmetric source and drain contacts.
**FIGS. 2A-I** illustrate an example process flow for forming a transistor with asymmetric source and drain contacts.
**FIG. 3** illustrates a cross-section of an example integrated circuit with asymmetric transistor contacts.
**FIG. 4** illustrates a flowchart for forming an integrated circuit with asymmetric transistor contacts.
**FIG. 5** is a top view of a wafer and dies that may be included in a microelectronic assembly.
**FIG. 6** is a cross-sectional side view of an integrated circuit device that may be included in a microelectronic assembly.
**FIGS. 7A-D** are perspective views of example planar, FinFET, gate-all-around, and stacked gate-all-around transistors.
**FIG. 8** is a cross-sectional side view of an integrated circuit device assembly that may include a microelectronic assembly.
**FIG. 9** is a block diagram of an example electrical device that may include a microelectronic assembly.

### DETAILED DESCRIPTION

The source and drain regions of transistors include electrical contacts to enable electrical connections to be formed to and from the transistors. These contacts are symmetrical and are formed on the frontside of an integrated circuit (e.g., above the source and drain). In general, larger contact sizes (e.g., wider, more contact area) are often preferable as they achieve lower resistance, which can improve performance. If the source and drain contacts are too large, however, parasitic capacitance may increase. For example, as the size of the source/drain contacts increases, the distance between the trenches of the source/drain contacts and the gate contact decreases. If the source/drain contacts and the gate contact become too close to each other, parasitic capacitance increases, which may lead to a higher propensity for shorting, thus reducing process yield. Thus, while larger source/drain contacts reduce resistance, they can also increase parasitic capacitance if they become too large, which may negate the performance gains from lower resistance.

Accordingly, this disclosure presents embodiments of semiconductor devices (e.g., integrated circuits) with asymmetric transistor source and drain contacts, along with methods of forming the same. In particular, one of the source or drain contacts may be formed on the frontside of the semiconductor device (e.g., above the source or drain), and the other may be formed on the backside (e.g., below the source or drain). The frontside contact may be the standard or usual size to avoid interfering with the gate/gate contact, but the backside contact may have a larger size (e.g., wider, more contact area) since gate interference is not a concern on the backside. For example, since there is no parallel gate line on the backside of the transistor, the backside contact size can be increased significantly without a capacitance penalty, such as by increasing the width and/or contact area of the backside contact relative to the frontside contact.

Further, the larger backside contact can be either the source contact or the drain contact depending on the performance implications in different embodiments. For example, if the source-side resistance is more dominant than drain-side resistance (e.g., due to a low bias on the source and a high bias on the drain), then the larger backside contact may be used for the source and the standard frontside contact may be used for the drain. Alternatively, if the opposite is true, then the larger backside contact may be used for the drain and the standard frontside contact may be used for the source.

The described solution provides various advantages. For example, this solution increases performance due to the lower access resistance provided by the larger backside source or drain contact. Moreover, since there is no backside gate contact, there is no meaningful increase in parasitic capacitance due to the larger backside source/drain contact, nor any increased propensity for shorting. The lower contact resistance without a capacitance penalty improves transistor performance and enables cell height scaling, which results in faster microprocessors and improved process technology.

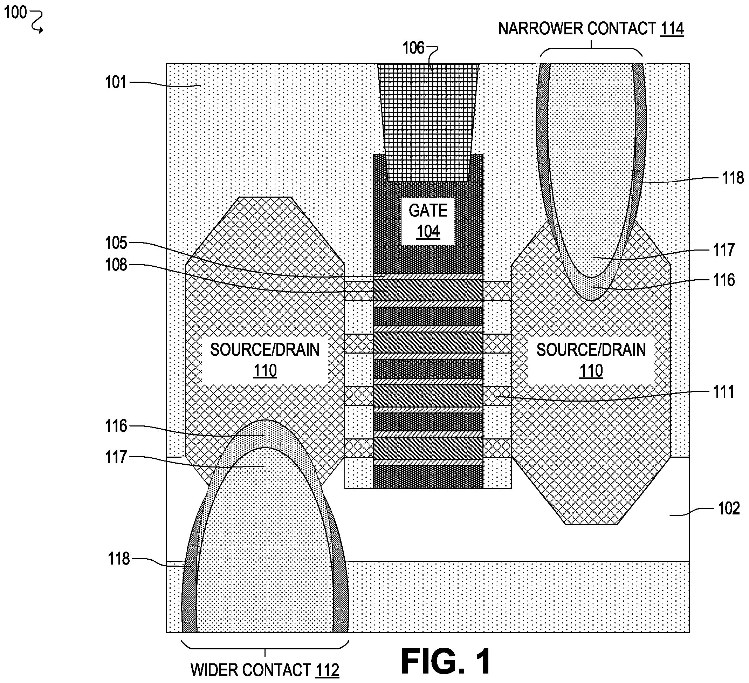

**FIG. 1** illustrates an example of a transistor 100 with asymmetric source and drain contacts. In the illustrated embodiment, one of the source/drain contacts 114 is on the frontside of the transistor 100 and the other source/drain contact 112 is on the backside of the transistor 100. Further, the backside contact 112 has a larger width and contact area than the frontside contact 114, which reduces resistance on the backside contact 112 without increasing parasitic capacitance. In some embodiments, the transistor 100 may be part of a semiconductor device such as an integrated circuit.

In the illustrated embodiment, the transistor 100 is a nanoribbon transistor, where nanoribbons 108 are used as the transistor channel. In particular, the transistor 100 includes source and drain regions 110 formed over a substrate 102, nanoribbons 108 extending between the source/drain regions 110, and a gate 104 formed around the nanoribbons 108. The nanoribbons 108 couple the source/drain regions 110 and serve as the channel of the transistor 100. The tips/ends 111 of the nanoribbons 108 are doped with the same dopants as the source/drain regions 110, which causes the source/drain regions 110 to effectively extend or protrude into the tips 111 of the nanoribbons 108. The gate 104 includes an associated gate oxide 106 formed around the nanoribbons 108 (e.g., between the gate 104 and the nanoribbons 108 to provide separation), along with an associated gate contact 106 formed over/above the gate 104. The source/drain regions 110 include frontside and backside source/drain contacts 114, 112, each of which includes a contact metal 116, a contact trench metal 117, and a contact trench liner 118. The remaining areas are filled with an inter-layer dielectric (ILD) 101 (e.g., an isolation oxide).

In the illustrated embodiment, the frontside and backside source/drain contacts 114, 112 are asymmetric. In particular, the backside source/drain contact 112 has a larger width (e.g., critical dimension) and contact area (e.g., area in contact with the source or drain region 110) than the frontside contact 114. Thus, in the illustrated embodiment, the backside contact 112 is referred to as the wider contact, and the frontside contact 114 is referred to as the narrower contact.

For example, since the gate 104 is on the frontside of the transistor 100 (e.g., above the substrate 102), the size of the backside contact 112 (e.g., width, contact area) can be increased significantly relative to the frontside contact 114 without a capacitance penalty, thus reducing resistance.

In some embodiments, for example, the backside (wider) contact 112 may have a width of -8-22 nanometers (nm), the frontside (narrower) contact 112 may have a width of ~6-16 nm, and the backside (wider) contact 112 may be ~2-6 nm wider than the frontside (narrower) contact 114. Thus, in these embodiments, the backside (wider) contact 112 may be -10-40% wider than the frontside (narrower) contact 114.

Further, the larger backside contact 112 can be either the source contact or the drain contact depending on the performance implications in different embodiments. For example, if the source-side resistance is more dominant than drain-side resistance (e.g., due to a low bias on the source and a high bias on the drain), then the larger backside contact 112 may be used for the source 110 and the standard frontside contact 114 may be used for the drain 110. Alternatively, if the opposite is true, then the larger backside contact 112 may be used for the drain 110 and the standard frontside contact may be used for the source 110.

The materials used to form the respective layers may vary in different embodiments. Examples of materials that may be used for each layer are provided below.

The substrate 102 may be made of any suitable material(s), including, without limitation, silicon.

The inter-layer dielectric (ILD) 101, also referred to as an isolation oxide, may be made of any suitable dielectric material(s), including, without limitation, silicon dioxide (SiO₂) (and/or other oxides of silicon), silicon oxynitride (SiON), and/or silicon oxycarbide (SiOC). Thus, in some embodiments, the ILD 101 may be made of material(s) that include elements such as silicon (Si), oxygen (O), nitrogen (N), and/or carbon (C).

The gate 104 may be made of any suitable conductive or metal material(s), including, without limitation, titanium (Ti), titanium nitride (TiN), aluminum (Al), titanium aluminide (TiAl), titanium aluminum nitride (TiAIN), titanium silicon nitride (TiSiN), nickel (Ni), platinum (Pt), molybdenum (Mo), and/or tungsten (W). Thus, in some embodiments, the gate 104 may be made of material(s) that include elements such as titanium (Ti), aluminum (Al), nickel (Ni), platinum (Pt), molybdenum (Mo), tungsten (W), nitrogen (N), and/or silicon (Si).

The gate oxide 105 may be made of any suitable dielectric material(s), including, without limitation, hafnium oxide (HfO₂), silicon dioxide (SiO₂) (or other oxides of silicon), silicon oxynitride (SiON), zirconium dioxide (ZrO₂), lanthanum oxide (La₂O₃), tantalum pentoxide (Ta₂O₅), HfSiO₂, ZrSiO₂, and/or LaSiO₂. Thus, in some embodiments, the gate oxide 105 may be made of material(s) that include elements such as hafnium (Hf), silicon (Si), oxygen (O), nitrogen (N), zirconium (Zr), lanthanum (La), and/or tantalum (Ta).

The gate contact 106 may be made of any suitable conductive or metal material(s), including, without limitation, cobalt (Co), tungsten (W), molybdenum (Mo), aluminum (Al), and/or copper (Cu).

The nanoribbons 108 may be made of any suitable material(s), including, without limitation, silicon (Si), germanium (Ge), and/or silicon germanium (SiGe) (e.g., with any Si-to-Ge ratio). Thus, in some embodiments, the nanoribbons 108 may be made of material(s) that include elements such as silicon (Si) and/or germanium (Ge).

The source and drain regions 110 (and doped nanoribbon tips 111) may be made of any suitable material(s), including, without limitation, doped silicon (Si) (e.g., phosphorous-doped Si, arsenic-doped Si) and/or doped silicon germanium (SiGe) (e.g., boron-doped SiGe with various percentages of Si and Ge). Thus, in some embodiments, the source and drain regions 110 (and doped nanoribbon tips 111) may be made of material(s) that include elements such as silicon (Si), germanium (Ge), phosphorous (P), arsenic (As), and/or boron (B).

The source/drain contacts 112, 114 may be made of any suitable material(s), including those described below with respect to the contact metal 116, contact trench metal 117, and contact trench liner 118.

The source/drain contact metal 116 may be made of any suitable conductive or metal material(s), including, without limitation, titanium (Ti), titanium nitride (TiN), aluminum (Al), titanium aluminide (TiAl), nickel (Ni), platinum (Pt), molybdenum (Mo), tungsten (W), scandium (Sc), erbium (Er), yttrium (Y), ytterbium (Yb), gadolinium (Gd), terbium (Tb), and/or dysprosium (Dy). Thus, in some embodiments, the source/drain contact metal 116 may be made of material(s) that include elements such as titanium (Ti), aluminum (Al), nickel (Ni), platinum (Pt), molybdenum (Mo), tungsten (W), scandium (Sc), erbium (Er), yttrium (Y), ytterbium (Yb), gadolinium (Gd), terbium (Tb), dysprosium (Dy), and/or nitrogen (N).

The contact trench 117 may be made of any suitable conductive or metal material(s), including, without limitation, cobalt (Co), tungsten (W), molybdenum (Mo), aluminum (Al), and/or copper (Cu).

The contact trench liner 118 may be made of any suitable dielectric material(s), including, without limitation, silicon oxynitride (SiON) and/or silicon oxycarbide (SiOC). Thus, in some embodiments, the contact trench liner 118 may be made of material(s) that include elements such as silicon (Si), oxygen (O), nitrogen (N), and/or carbon (C).

It should be appreciated that the illustrated embodiment is merely shown as an example and other variations are also possible. In various embodiments, transistor 100 may be implemented using other types, numbers, and/or arrangements of layers and materials than those shown and described with respect to FIG. 1. For example, the size and/or materials of the layers may vary. Moreover, certain components of transistor 100 may be added, replaced, omitted, and/or rearranged. For example, the substrate 102 may not be present in some embodiments, as it may be completely grinded/thinned away during fabrication. In some embodiments, the frontside source/drain contact may be the larger contact if the gate is formed on the backside instead of the frontside. Further, while transistor 100 is a nanoribbon transistor, asymmetric source/drain contacts can be implemented on any type of transistor, including nanoribbon transistors, gate-all-around (GAA) transistors, fin field-effect transistors (FinFET), planar transistors, and two-dimensional (2D) transistors (e.g., made of 2D semiconductor materials), among others. In various embodiments, transistors with asymmetric source/drain contacts may be used for power delivery or signaling on semiconductor devices such as integrated circuits. In some embodiments, for example, transistors with asymmetric source/drain contacts may be used for backside power delivery (e.g., IC 300), where the backside source/drain contact is larger than the frontside source/drain contact, and power delivery is provided from the backside of the device. In some embodiments, the narrower frontside contact may be coupled to a frontside interconnect, while the wider backside contact may be coupled to a backside interconnect.

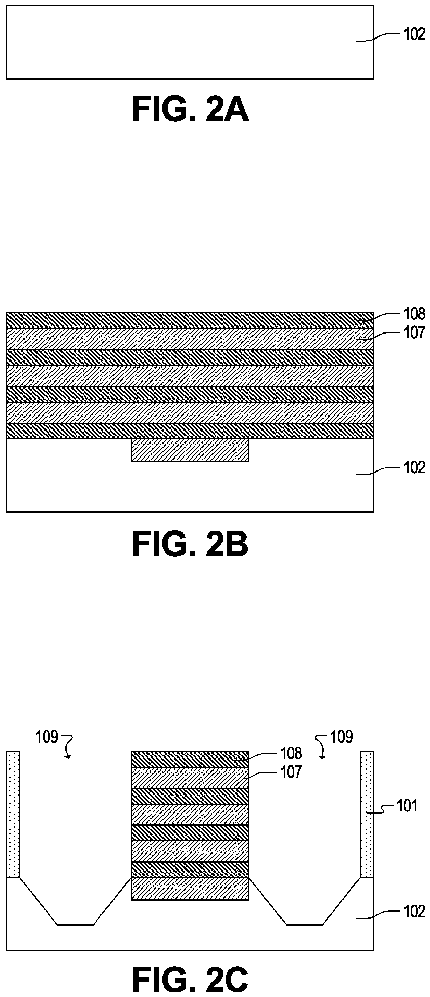

**FIGS. 2A-I** illustrate an example process flow for forming a transistor 100 with asymmetric source and drain contacts. In the illustrated example, the process flow is used to form the transistor 100 of FIG. 1. It will be appreciated in light of the present disclosure that the illustrated process flow is only one example methodology for arriving at a transistor with asymmetric source/drain contacts.

In FIG. 2A, a substrate 102 is received. In some embodiments, the substrate 102 may be a silicon substrate.

In FIG. 2B, a superlattice with alternating silicon germanium (SiGe) 107 and silicon (Si) 108 layers is formed over the substrate 102. In the illustrated embodiment, the Si layers 107 are the nanoribbons that will serve as the channel of the transistor 100 once complete.

In FIG. 2C, the SiGe/Si superlattice layers 107, 108 are etched away in the areas 109 where the respective source and drain regions 110 will be formed.

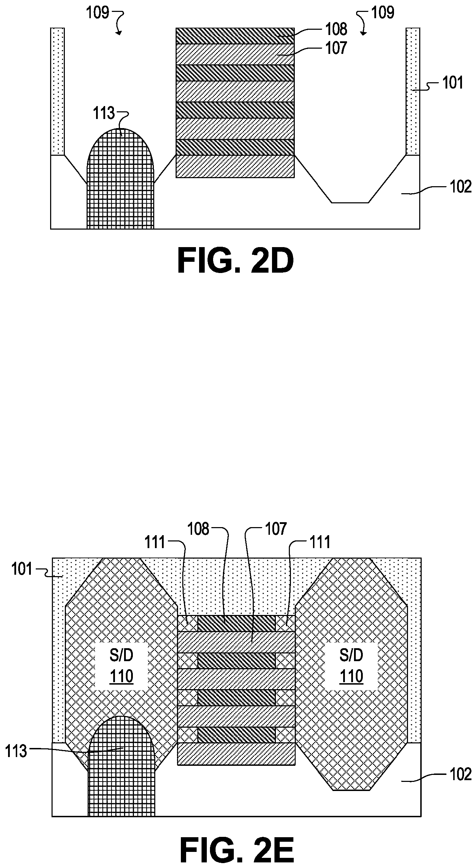

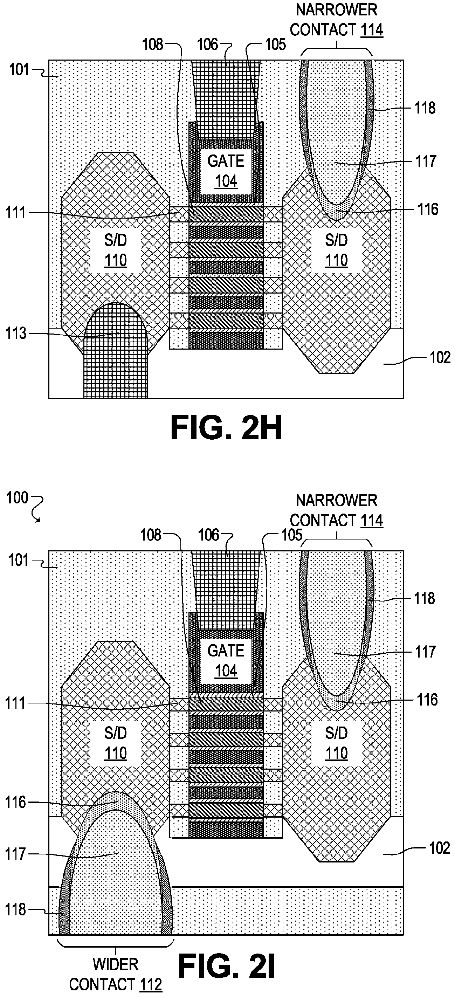

In FIG. 2D, a sacrificial dummy backside contact 113 is formed for one of the source or drain regions 110, which will subsequently be replaced with the actual backside contact during backside processing (e.g., as described below with respect to FIG. 2I).

In FIG. 2E, the source and drain regions 110 are epitaxially grown. Further, the tips 111 of the silicon nanoribbons 108 are doped, which effectively causes the source and drain regions 110 to extend into the nanoribbons 108.

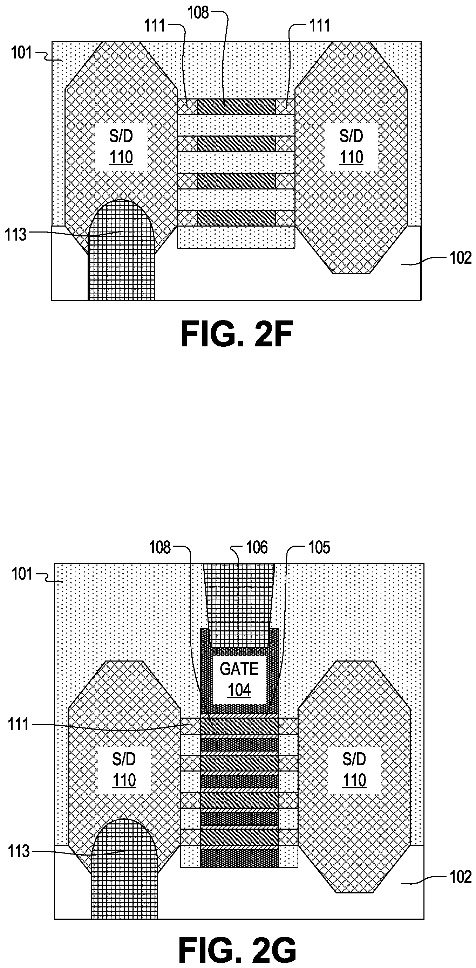

In FIG. 2F, the SiGe layers 107 are removed (e.g., etched) to release the nanoribbons 107.

In FIG. 2G, the gate oxide 105, gate 104, and gate contact 106 are formed.

For example, the gate oxide/dielectric 105 is formed over/around the released nanoribbon channels 108, and the gate 104 is then formed over/around the gate oxide 105 and nanoribbon channels 108. The gate contact 106 is then formed above/over the gate 104.

In FIG. 2H, the narrower frontside contact 114 is formed over one of the source or drain regions 110, which includes a contact metal 116, a contact trench metal 117, and a contact trench liner 118.

At this point, any remaining frontside processing may be performed (not shown), such as frontside metallization/interconnect patterning. Once the frontside processing is complete, a carrier substrate may be attached to the top of the device (not shown), the device may be flipped, and the original substrate 102 may be grinded/thinned before performing backside processing (e.g., to expose the dummy contact along with any other backside connections).

In FIG. 2I, the dummy contact 113 is removed (e.g., etched) and the wider backside contact 112 is formed in its place. For example, the backside contact 112 may be formed under the other one of the source or drain regions 110 and may include a contact metal 116, a contact trench metal 117, and a contact trench liner 118. Further, since no gate 104 is present on the backside of the device, the backside contact 112 is formed with a larger width and contact area than the frontside contact 114, thus reducing resistance and increasing performance.

At this point, any remaining backside or other processing may be performed to complete the device (not shown), such as backside metallization/interconnect patterning.

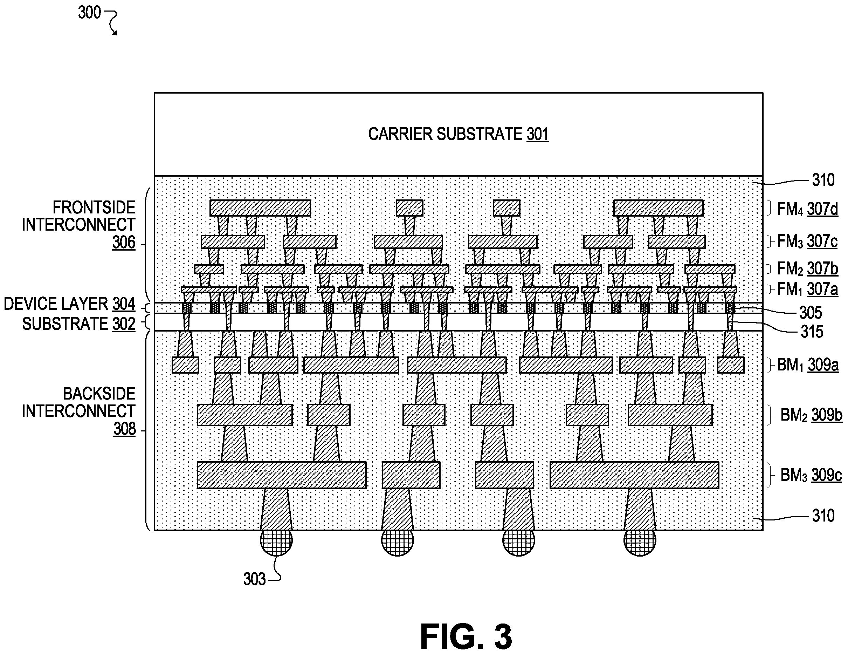

**FIG. 3** illustrates a cross-section of an integrated circuit (IC) 300 with asymmetric transistor contacts in accordance with certain embodiments. In the illustrated embodiment, for example, IC 300 includes a layer 304 of transistors 305, and at least some of the transistors 305 have asymmetric source and drain contacts (e.g., different contact widths and/or contact areas).

In the illustrated embodiment, IC 300 includes a thinned silicon substrate 302, a device layer 304 over the silicon substrate 302, a frontside interconnect 306 over the device layer 304, and a backside interconnect 308 under the device layer 304 and the silicon substrate 302. IC 300 also includes a carrier substrate 301 attached above the frontside interconnect 306 for structural support, along with conductive (e.g., metal) bumps 303 on the bottom surface to electrically couple IC 300 with another electronic device (e.g., an IC package, another IC die/chip, etc.).

The device layer 304 includes one or more transistors 305 and/or other semiconductor devices. Moreover, at least some of the transistors 305 have asymmetric source and drain contacts. In some embodiments, for example, the transistors 305 may be implemented using the design of transistor 100. For example, transistors 305 with asymmetric contacts may have one contact on the frontside of IC 300 (e.g., above the source or drain) and another contact on the backside of IC 300 (e.g., below the other of the source or drain). In the illustrated embodiment, for example, some of the transistors 305 are shown with connections 315 to the backside source or drain contact. Moreover, the contact on the backside may have greater width and/or contact area than the contact on the frontside, as described throughout this disclosure.

The frontside interconnect 306 include multiple frontside metal (FM) layers (FM₁₋₄) 307a-d (e.g., primarily for signaling), and the backside interconnect 308 includes multiple backside metal (BM) layers (BM₁₋₃) 309a-c (e.g., primarily for power delivery/ground connections). The remaining areas are filled with one or more inter-layer dielectrics (ILDs) 310.

In the illustrated embodiment, the device layer 304 and interconnects 306, 308 collectively implement logic circuitry with associated power (V_{DD}), ground (Vss), and signal networks. In some embodiments, for example, the logic circuitry may be or may include processing circuitry, memory circuitry, storage circuitry, and/or communication circuitry.

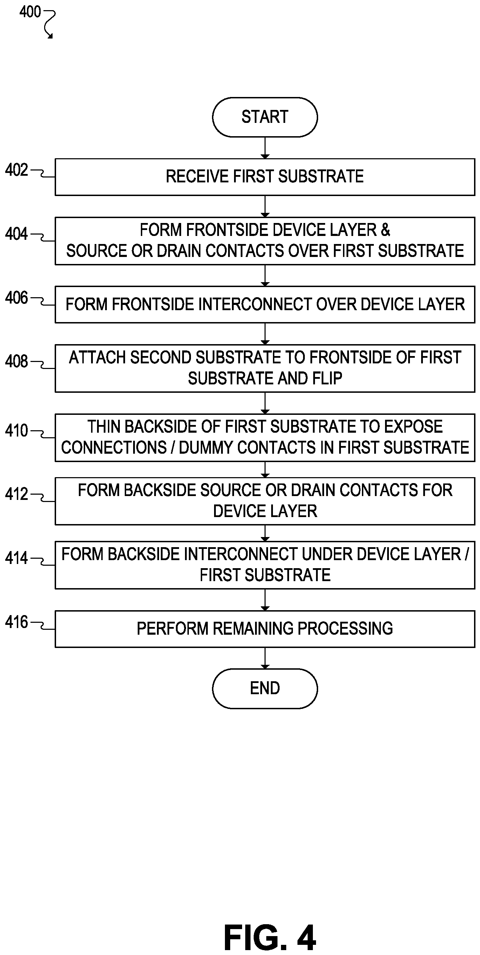

An example process flow for forming IC 300 is described below in connection with FIG. 4.

**FIG. 4** illustrates a flowchart 400 for forming an integrated circuit (IC) with asymmetric transistor contacts in accordance with certain embodiments. It will be appreciated in light of the present disclosure that the illustrated process flow is only one example methodology for arriving at the example IC devices shown and described throughout this disclosure (e.g., transistor 100, IC 300). The steps of the illustrated process flow may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metal-organic chemical vapor deposition (MOCVD), molecular beam epitaxy (MBE), atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The illustrated process flow may be used to form one or more IC dies that respectively include a device layer along with frontside and backside interconnects above and below the device layer (e.g., for signaling and power delivery). In some embodiments, the device layer and interconnects may collectively implement logic circuitry and associated signal, power, and ground nets on the respective IC dies. Moreover, at least some of the transistors in the device layer may include asymmetric source and drain contacts, as described throughout this disclosure.

The flowchart begins at block 402 by receiving a first substrate. In some embodiments, the first substrate may be a wafer or panel and may include silicon (Si). Further, the first substrate may be pre-patterned with one or more through-silicon vias (TSVs), or alternatively, the first substrate may be received without any pre-patterned TSVs and one or more TSVs may be subsequently formed in the substrate.

The flowchart then proceeds to block 404 to form a device layer, along with source or drain contacts for transistors in the device layer, over the first substrate (e.g., on the frontside of the first substrate), which may be referred to as the frontside device layer and frontside source or drain contacts. The device layer may include one or more semiconductor devices, such as transistors (e.g., CMOS, PMOS, NMOS), to implement the logic circuitry of the respective IC dies. Further, at least some of the transistors may be designed with asymmetric source and drain contacts, where one of the contacts is on the frontside of the first substrate (e.g., above the source or drain) and the other contact is on the backside of the first substrate (e.g., below the other of the source or drain), and the respective frontside/backside contacts have different widths and/or contact areas. In some embodiments, for example, the frontside contacts may have a smaller width and/or smaller contact area than the backside contacts (e.g., due to the presence of the gate on the frontside but not the backside). Thus, for those transistors, the frontside source or drain contacts are formed at block 404, while the backside source or drain contacts are formed at block 412, as described further below. In some embodiments, however, at block 404, dummy backside contacts may be formed in a portion of the source or the drain to aid in forming the actual backside contacts at block 412. Finally, at block 404, one or more vias may be formed through the device layer to form electrical connections to the TSVs in the first substrate.

The flowchart then proceeds to block 406 to form a first interconnect over the device layer (e.g., on the frontside of the first substrate), which may be referred to as the frontside interconnect. For example, multiple conductive (e.g., metal) layers may be formed over the device layer, along with intervening dielectric layers separating the conductive layers. The conductive layers, which may also be referred to as metal layers, may be made of one or more electrically-conductive materials that include one or more metals (e.g., any of the metals/alloys described throughout this disclosure). Further, the dielectric layers may include one or more dielectric materials (e.g., any of the dielectric materials described throughout this disclosure).

Moreover, conductive traces may be patterned (e.g., etched) in the frontside conductive layers, and vias may be formed between the conductive layers (e.g., through the intervening dielectric layers) to electrically couple traces in different conductive layers. The conductive traces and vias patterned in and between the frontside conductive layers may collectively form one or more signal, power, and/or ground nets for the logic circuitry on the respective IC dies (e.g., networks of conductive traces that provide signaling, power, and ground connections).

The signal nets (e.g., V_{IN}, V_{OUT}) may include one or more conductive traces used for signaling (e.g., electrical connections between inputs and outputs of devices/transistors in the device layer), which may also be referred to as signal traces or signal routing. Further, the signal nets in the frontside interconnect may be connected to one or more corresponding signal nets formed in the backside interconnect for off-die signal routing (e.g., as described below with respect to block 414).

The power nets (e.g., V_{DD} or Vcc) may include one or more conductive traces for delivering power (e.g., electrical connections between the device layer and one or more power supply terminals), which may also be referred to as power traces or power routing. Further, the power nets in the frontside interconnect may be connected to one or more corresponding power nets formed in the backside interconnect (e.g., as described below with respect to block 414).

The ground nets (e.g., Vss) may include one or more conductive traces for providing ground connections (e.g., electrical connections between the device layer and one or more ground/reference terminals), which may also be referred to as ground traces or ground routing. Further, the ground nets in the frontside interconnect may be connected to one or more corresponding ground nets formed in the backside interconnect (e.g., as described below with respect to block 414).

The flowchart then proceeds to block 408 to attach or bond a second substrate to the frontside of the first substrate (e.g., over the frontside interconnect) and then flip the first substrate over. The second substrate may be referred to as a carrier substrate (e.g., a silicon carrier wafer or panel).

The flowchart then proceeds to block 410 to thin (e.g., grind) the backside of the first substrate to expose the connections (e.g., TSVs) formed in the first substrate and/or the dummy source or drain contacts formed at block 404.

The flowchart then proceeds to block 412 to form source or drain contacts under the device layer and/or the first substrate (e.g., on the backside of the first substrate), which may be referred to as the backside source or drain contacts. As explained above, the backside contacts may have a larger width and/or larger contact area than the frontside contacts (e.g., due to the lack of a gate on the backside and the presence of a gate on the frontside). In some embodiments, the dummy backside contacts may be etched out of the source or drain and the actual backside contacts may be formed in their place.

The flowchart then proceeds to block 414 to form a second interconnect under the device layer and the first substrate (e.g., on the backside of the first substrate), which may be referred to as the backside interconnect.

For example, multiple conductive (e.g., metal) layers may be formed below the device layer and first substrate, along with intervening dielectric layers separating the conductive layers. The conductive layers, which may also be referred to as backside metal layers, may be made of one or more electrically-conductive materials that include one or more metals (e.g., any of the metals/alloys described throughout this disclosure). Further, the dielectric layers may include one or more dielectric materials (e.g., any of the dielectric materials described throughout this disclosure).

Moreover, conductive traces may be patterned (e.g., etched) in the backside conductive layers, and vias may be formed between the conductive layers (e.g., through the intervening dielectric layers) to electrically couple traces in different conductive layers. The conductive traces and vias patterned in and between the backside conductive layers may collectively form one or more backside power, ground, and/or signal nets for the logic circuitry on the respective IC dies (e.g., networks of conductive traces that provide power, ground, and/or off-chip signal routing connections). For example, the backside power and ground nets may electrically couple the corresponding frontside power and ground nets to one or more backside power supply terminals and ground terminals, respectively (e.g., through the vias in the first substrate and device layer). Moreover, the backside signal net may electrically couple the corresponding frontside signal net to one or more off-die or off-chip components (e.g., through the vias in the first substrate and device layer).

In this manner, the backside interconnect is electrically coupled to the frontside interconnect (e.g., through the vias in the first substrate and device layer) to provide power delivery and ground connections, along with off-die or off-chip signal routing.

The flowchart then proceeds to block 416 to perform any remaining processing, such as inter-layer dielectric (ILD) filling, planarization, interconnect bump formation, etc. In wafer or panel process flows, the completed wafer or panel may be diced to singulate the IC dies on the wafer or panel. The singulated IC dies may then be incorporated into an IC package, circuit board, electronic device, system, etc.

At this point, the flowchart may be complete. In some embodiments, however, the flowchart may restart and/or certain blocks may be repeated. For example, in some embodiments, the flowchart may restart at block 402 to continue forming one or more ICs with the same or similar design.

### Example Integrated Circuit Embodiments

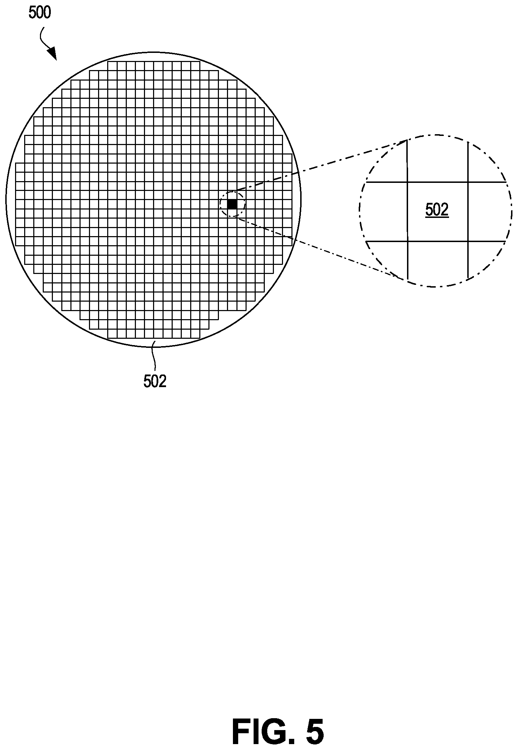

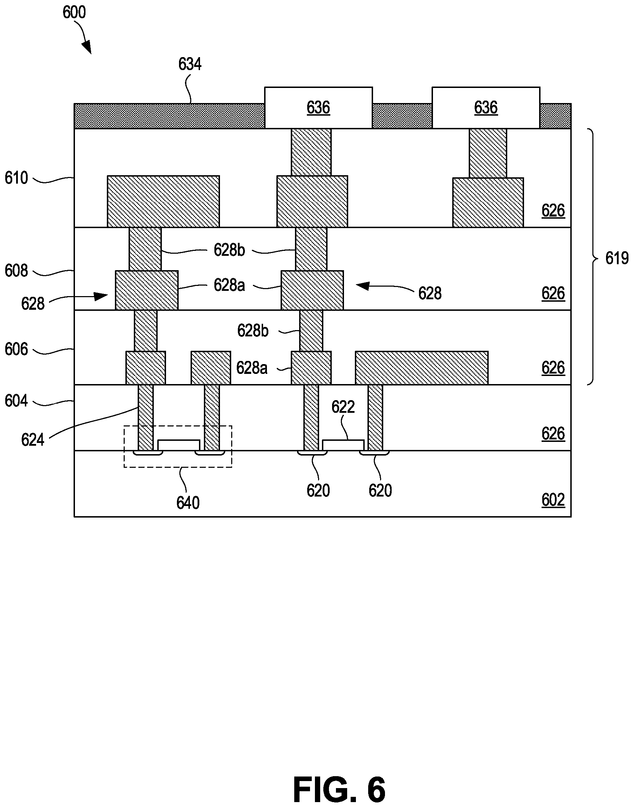

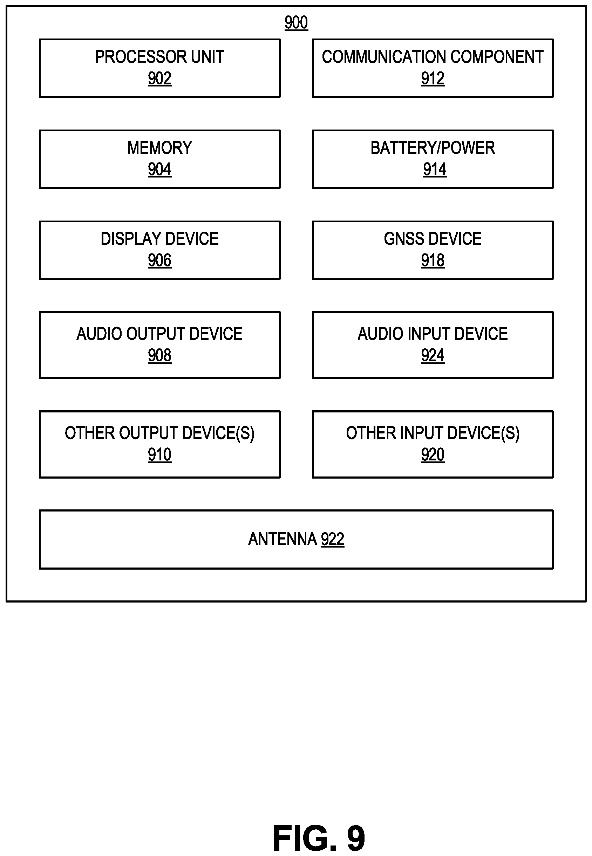

**FIG. 5** is a top view of a wafer 500 and dies 502 that may be included in, or may include, any of the embodiments disclosed herein. In some embodiments, for example, the wafer 500 may include dies 502 with transistors that have asymmetric contacts (e.g., transistor 100, IC die 300). The wafer 500 may be composed of semiconductor material and may include one or more dies 502 having integrated circuit structures formed on a surface of the wafer 500. The individual dies 502 may be a repeating unit of an integrated circuit product that includes any suitable integrated circuit. After the fabrication of the semiconductor product is complete, the wafer 500 may undergo a singulation process in which the dies 502 are separated from one another to provide discrete "chips" of the integrated circuit product. The die 502 may be any of the dies disclosed herein. The die 502 may include one or more transistors (e.g., some of the transistors 640 of FIG. 6, discussed below), supporting circuitry to route electrical signals to the transistors, passive components (e.g., signal traces, resistors, capacitors, or inductors), and/or any other integrated circuit components. In some embodiments, the wafer 500 or the die 502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 502. For example, a memory array formed by multiple memory devices may be formed on a same die 502 as a processor unit (e.g., the processor unit 902 of FIG. 9) or other logic that is configured to store information in the memory devices or execute instructions stored in the memory array. Various ones of the microelectronic assemblies disclosed herein may be manufactured using a die-to-wafer assembly technique in which some dies are attached to a wafer 500 that include others of the dies, and the wafer 500 is subsequently singulated.

**FIG. 6** is a cross-sectional side view of an integrated circuit device 600 that may be included in, or may include, any of the embodiments disclosed herein (e.g., transistor 100, IC 300). One or more of the integrated circuit devices 600 may be included in one or more dies 502 (FIG. 5). The integrated circuit device 600 may be formed on a die substrate 602 (e.g., the wafer 500 of FIG. 5) and may be included in a die (e.g., the die 502 of FIG. 5). The die substrate 602 may be a semiconductor substrate composed of semiconductor material systems including, for example, n-type or p-type materials systems (or a combination of both). The die substrate 602 may include, for example, a crystalline substrate formed using a bulk silicon or a silicon-on-insulator (SOI) substructure. In some embodiments, the die substrate 602 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 602. Although a few examples of materials from which the die substrate 602 may be formed are described here, any material that may serve as a foundation for an integrated circuit device 600 may be used. The die substrate 602 may be part of a singulated die (e.g., the dies 502 of FIG. 5) or a wafer (e.g., the wafer 500 of FIG. 5).

The integrated circuit device 600 may include one or more device layers 604 disposed on the die substrate 602. The device layer 604 may include features of one or more transistors 640 (e.g., metal oxide semiconductor field-effect transistors (MOSFETs)) formed on the die substrate 602. The transistors 640 may include, for example, one or more source and/or drain (S/D) regions 620, a gate 622 to control current flow between the S/D regions 620, and one or more S/D contacts 624 to route electrical signals to/from the S/D regions 620. The transistors 640 may include additional features not depicted for the sake of clarity, such as device isolation regions, gate contacts, and the like. The transistors 640 are not limited to the type and configuration depicted in FIG. 6 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

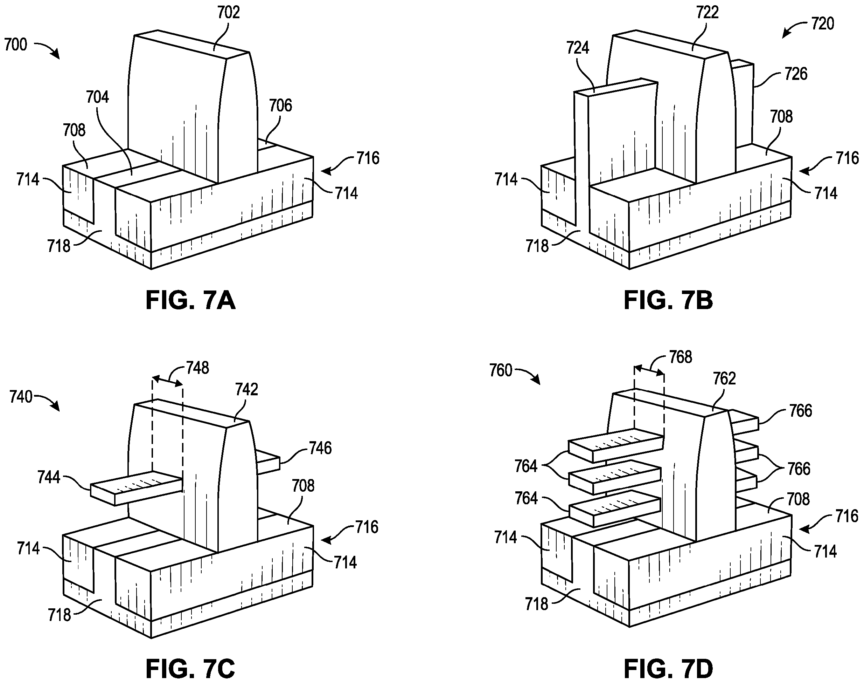

**FIGS. 7A-D** are simplified perspective views of example planar, FinFET, gate-all-around, and stacked gate-all-around transistors. In some embodiments, these transistors may be implemented with asymmetric source and drain contacts (e.g., similar to transistor 100). The transistors illustrated in FIGS. 7A-7D are formed on a substrate 716 having a surface 708. Isolation regions 714 separate the source and drain regions of the transistors from other transistors and from a bulk region 718 of the substrate 716.

FIG. 7A is a perspective view of an example planar transistor 700 comprising a gate 702 that controls current flow between a source region 704 and a drain region 706. The transistor 700 is planar in that the source region 704 and the drain region 706 are planar with respect to the substrate surface 708.

FIG. 7B is a perspective view of an example FinFET transistor 720 comprising a gate 722 that controls current flow between a source region 724 and a drain region 726. The transistor 720 is non-planar in that the source region 724 and the drain region 726 comprise "fins" that extend upwards from the substrate surface 728. As the gate 722 encompasses three sides of the semiconductor fin that extends from the source region 724 to the drain region 726, the transistor 720 can be considered a tri-gate transistor. FIG. 7B illustrates one S/D fin extending through the gate 722, but multiple S/D fins can extend through the gate of a FinFET transistor.

FIG. 7C is a perspective view of a gate-all-around (GAA) transistor 740 comprising a gate 742 that controls current flow between a source region 744 and a drain region 746. The transistor 740 is non-planar in that the source region 744 and the drain region 746 are elevated from the substrate surface 728.

FIG. 7D is a perspective view of a GAA transistor 760 comprising a gate 762 that controls current flow between multiple elevated source regions 764 and multiple elevated drain regions 766. The transistor 760 is a stacked GAA transistor as the gate controls the flow of current between multiple elevated S/D regions stacked on top of each other. The transistors 740 and 760 are considered gate-all-around transistors as the gates encompass all sides of the semiconductor portions that extends from the source regions to the drain regions. The transistors 740 and 760 can alternatively be referred to as nanowire, nanosheet, or nanoribbon transistors depending on the width (e.g., widths 748 and 768 of transistors 740 and 760, respectively) of the semiconductor portions extending through the gate.

Returning to FIG. 6, a transistor 640 may include a gate 622 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 640 along the source-channel-drain direction, the gate electrode may consist of a U-shaped structure that includes a bottom portion substantially parallel to the surface of the die substrate 602 and two sidewall portions that are substantially perpendicular to the top surface of the die substrate 602. In other embodiments, at least one of the metal layers that form the gate electrode may simply be a planar layer that is substantially parallel to the top surface of the die substrate 602 and does not include sidewall portions substantially perpendicular to the top surface of the die substrate 602. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 620 may be formed within the die substrate 602 adjacent to the gate 622 of individual transistors 640. The S/D regions 620 may be formed using an implantation/diffusion process or an etching/deposition process, for example. In the former process, dopants such as boron, aluminum, antimony, phosphorous, or arsenic may be ion-implanted into the die substrate 602 to form the S/D regions 620. An annealing process that activates the dopants and causes them to diffuse farther into the die substrate 602 may follow the ion-implantation process. In the latter process, the die substrate 602 may first be etched to form recesses at the locations of the S/D regions 620. An epitaxial deposition process may then be carried out to fill the recesses with material that is used to fabricate the S/D regions 620. In some implementations, the S/D regions 620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 620 may be formed using one or more alternate semiconductor materials such as germanium or a group III-V material or alloy. In further embodiments, one or more layers of metal and/or metal alloys may be used to form the S/D regions 620.

Electrical signals, such as power and/or input/output (I/O) signals, may be routed to and/or from the devices (e.g., transistors 640) of the device layer 604 through one or more interconnect layers disposed on the device layer 604 (illustrated in FIG. 6 as interconnect layers 606-610). For example, electrically conductive features of the device layer 604 (e.g., the gate 622 and the S/D contacts 624) may be electrically coupled with the interconnect structures 628 of the interconnect layers 606-610. The one or more interconnect layers 606-610 may form a metallization stack (also referred to as an "ILD stack") 619 of the integrated circuit device 600.

The interconnect structures 628 may be arranged within the interconnect layers 606-610 to route electrical signals according to a wide variety of designs; in particular, the arrangement is not limited to the particular configuration of interconnect structures 628 depicted in FIG. 6. Although a particular number of interconnect layers 606-610 is depicted in FIG. 6, embodiments of the present disclosure include integrated circuit devices having more or fewer interconnect layers than depicted.

In some embodiments, the interconnect structures 628 may include lines 628a and/or vias 628b filled with an electrically conductive material such as a metal. The lines 628a may be arranged to route electrical signals in a direction of a plane that is substantially parallel with a surface of the die substrate 602 upon which the device layer 604 is formed. For example, the lines 628a may route electrical signals in a direction in and out of the page and/or in a direction across the page from the perspective of FIG. 6. The vias 628b may be arranged to route electrical signals in a direction of a plane that is substantially perpendicular to the surface of the die substrate 602 upon which the device layer 604 is formed. In some embodiments, the vias 628b may electrically couple lines 628a of different interconnect layers 606-610 together.

The interconnect layers 606-610 may include a dielectric material 626 disposed between the interconnect structures 628, as shown in FIG. 6. In some embodiments, dielectric material 626 disposed between the interconnect structures 628 in different ones of the interconnect layers 606-610 may have different compositions; in other embodiments, the composition of the dielectric material 626 between different interconnect layers 606-610 may be the same. The device layer 604 may include a dielectric material 626 disposed between the transistors 640 and a bottom layer of the metallization stack as well. The dielectric material 626 included in the device layer 604 may have a different composition than the dielectric material 626 included in the interconnect layers 606-610; in other embodiments, the composition of the dielectric material 626 in the device layer 604 may be the same as a dielectric material 626 included in any one of the interconnect layers 606-610.

A first interconnect layer 606 (referred to as Metal 1 or "M1") may be formed directly on the device layer 604. In some embodiments, the first interconnect layer 606 may include lines 628a and/or vias 628b, as shown. The lines 628a of the first interconnect layer 606 may be coupled with contacts (e.g., the S/D contacts 624) of the device layer 604. The vias 628b of the first interconnect layer 606 may be coupled with the lines 628a of a second interconnect layer 608.

The second interconnect layer 608 (referred to as Metal 2 or "M2") may be formed directly on the first interconnect layer 606. In some embodiments, the second interconnect layer 608 may include via 628b to couple the lines 628 of the second interconnect layer 608 with the lines 628a of a third interconnect layer 610. Although the lines 628a and the vias 628b are structurally delineated with a line within individual interconnect layers for the sake of clarity, the lines 628a and the vias 628b may be structurally and/or materially contiguous (e.g., simultaneously filled during a dual-damascene process) in some embodiments.

The third interconnect layer 610 (referred to as Metal 3 or "M3") (and additional interconnect layers, as desired) may be formed in succession on the second interconnect layer 608 according to similar techniques and configurations described in connection with the second interconnect layer 608 or the first interconnect layer 606. In some embodiments, the interconnect layers that are "higher up" in the metallization stack 619 in the integrated circuit device 600 (i.e., farther away from the device layer 604) may be thicker that the interconnect layers that are lower in the metallization stack 619, with lines 628a and vias 628b in the higher interconnect layers being thicker than those in the lower interconnect layers.

The integrated circuit device 600 may include a solder resist material 634 (e.g., polyimide or similar material) and one or more conductive contacts 636 formed on the interconnect layers 606-610. In FIG. 6, the conductive contacts 636 are illustrated as taking the form of bond pads. The conductive contacts 636 may be electrically coupled with the interconnect structures 628 and configured to route the electrical signals of the transistor(s) 640 to external devices. For example, solder bonds may be formed on the one or more conductive contacts 636 to mechanically and/or electrically couple an integrated circuit die including the integrated circuit device 600 with another component (e.g., a printed circuit board). The integrated circuit device 600 may include additional or alternate structures to route the electrical signals from the interconnect layers 606-610; for example, the conductive contacts 636 may include other analogous features (e.g., posts) that route the electrical signals to external components. The conductive contacts 636 may serve as any of the conductive contacts described throughout this disclosure.

In some embodiments in which the integrated circuit device 600 is a double-sided die, the integrated circuit device 600 may include another metallization stack (not shown) on the opposite side of the device layer(s) 604. This metallization stack may include multiple interconnect layers as discussed above with reference to the interconnect layers 606-610, to provide conductive pathways (e.g., including conductive lines and vias) between the device layer(s) 604 and additional conductive contacts (not shown) on the opposite side of the integrated circuit device 600 from the conductive contacts 636. These additional conductive contacts may serve as any of the conductive contacts described throughout this disclosure.

In other embodiments in which the integrated circuit device 600 is a double-sided die, the integrated circuit device 600 may include one or more through silicon vias (TSVs) through the die substrate 602; these TSVs may make contact with the device layer(s) 604, and may provide conductive pathways between the device layer(s) 604 and additional conductive contacts (not shown) on the opposite side of the integrated circuit device 600 from the conductive contacts 636. These additional conductive contacts may serve as any of the conductive contacts described throughout this disclosure. In some embodiments, TSVs extending through the substrate can be used for routing power and ground signals from conductive contacts on the opposite side of the integrated circuit device 600 from the conductive contacts 636 to the transistors 640 and any other components integrated into the die 600, and the metallization stack 619 can be used to route I/O signals from the conductive contacts 636 to transistors 640 and any other components integrated into the die 600.

Multiple integrated circuit devices 600 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

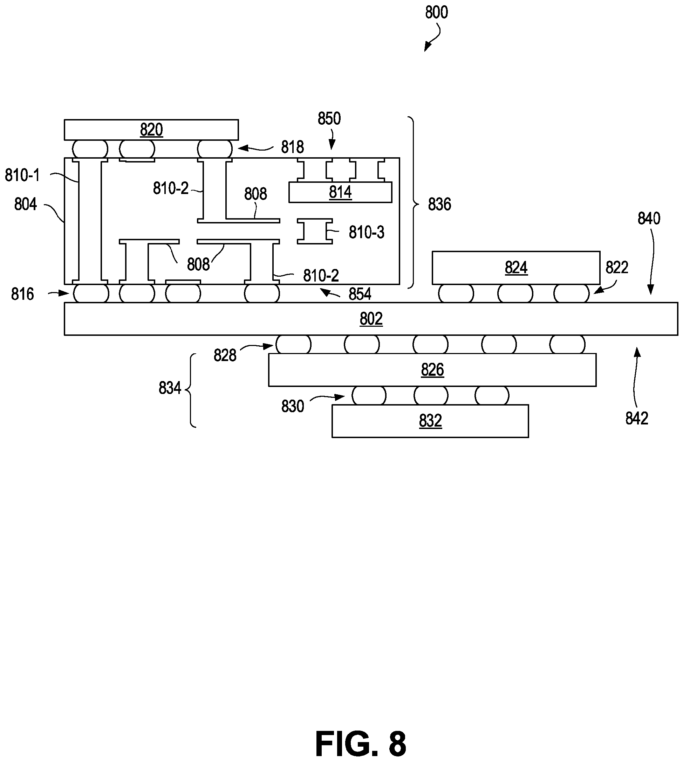

**FIG. 8** is a cross-sectional side view of an integrated circuit device assembly 800 that may include any of the embodiments disclosed herein (e.g., one or more integrated circuits with transistors that have asymmetric source and drain contacts, such as transistor 100 and IC 300). In some embodiments, the integrated circuit device assembly 800 may be a microelectronic assembly. The integrated circuit device assembly 800 includes a number of components disposed on a circuit board 802 (which may be a motherboard, system board, mainboard, etc.). The integrated circuit device assembly 800 includes components disposed on a first face 840 of the circuit board 802 and an opposing second face 842 of the circuit board 802; generally, components may be disposed on one or both faces 840 and 842. Any of the integrated circuit components discussed below with reference to the integrated circuit device assembly 800 may take the form of any suitable ones of the embodiments of the microelectronic assemblies disclosed herein.

In some embodiments, the circuit board 802 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 802. In other embodiments, the circuit board 802 may be a non-PCB substrate. The integrated circuit device assembly 800 illustrated in FIG. 8 includes a package-on-interposer structure 836 coupled to the first face 840 of the circuit board 802 by coupling components 816. The coupling components 816 may electrically and mechanically couple the package-on-interposer structure 836 to the circuit board 802, and may include solder balls (as shown in FIG. 8), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 816 may serve as the coupling components illustrated or described for any of the substrate assembly or substrate assembly components described herein, as appropriate.

The package-on-interposer structure 836 may include an integrated circuit component 820 coupled to an interposer 804 by coupling components 818. The coupling components 818 may take any suitable form for the application, such as the forms discussed above with reference to the coupling components 816. Although a single integrated circuit component 820 is shown in FIG. 8, multiple integrated circuit components may be coupled to the interposer 804; indeed, additional interposers may be coupled to the interposer 804. The interposer 804 may provide an intervening substrate used to bridge the circuit board 802 and the integrated circuit component 820.

The integrated circuit component 820 may be a packaged or unpackaged integrated circuit product that includes one or more integrated circuit dies (e.g., the die 502 of FIG. 5, the integrated circuit device 600 of FIG. 6) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 820, a single monolithic integrated circuit die comprises solder bumps attached to contacts on the die. The solder bumps allow the die to be directly attached to the interposer 804. The integrated circuit component 820 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 820 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 820 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 820 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 804 may spread connections to a wider pitch or reroute a connection to a different connection. For example, the interposer 804 may couple the integrated circuit component 820 to a set of ball grid array (BGA) conductive contacts of the coupling components 816 for coupling to the circuit board 802. In the embodiment illustrated in FIG. 8, the integrated circuit component 820 and the circuit board 802 are attached to opposing sides of the interposer 804; in other embodiments, the integrated circuit component 820 and the circuit board 802 may be attached to a same side of the interposer 804. In some embodiments, three or more components may be interconnected by way of the interposer 804.

In some embodiments, the interposer 804 may be formed as a PCB, including multiple metal layers separated from one another by layers of dielectric material and interconnected by electrically conductive vias. In some embodiments, the interposer 804 may be formed of an epoxy resin, a fiberglass-reinforced epoxy resin, an epoxy resin with inorganic fillers, a ceramic material, or a polymer material such as polyimide. In some embodiments, the interposer 804 may be formed of alternate rigid or flexible materials that may include the same materials described above for use in a semiconductor substrate, such as silicon, germanium, and other group III-V and group IV materials. The interposer 804 may include metal interconnects 808 and vias 810, including but not limited to through hole vias 810-1 (that extend from a first face 850 of the interposer 804 to a second face 854 of the interposer 804), blind vias 810-2 (that extend from the first or second faces 850 or 854 of the interposer 804 to an internal metal layer), and buried vias 810-3 (that connect internal metal layers).

In some embodiments, the interposer 804 can comprise a silicon interposer. Through silicon vias (TSV) extending through the silicon interposer can connect connections on a first face of a silicon interposer to an opposing second face of the silicon interposer. In some embodiments, an interposer 804 comprising a silicon interposer can further comprise one or more routing layers to route connections on a first face of the interposer 804 to an opposing second face of the interposer 804.

The interposer 804 may further include embedded devices 814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 804. The package-on-interposer structure 836 may take the form of any of the package-on-interposer structures known in the art. In embodiments where the interposer is a non-printed circuit board

The integrated circuit device assembly 800 may include an integrated circuit component 824 coupled to the first face 840 of the circuit board 802 by coupling components 822. The coupling components 822 may take the form of any of the embodiments discussed above with reference to the coupling components 816, and the integrated circuit component 824 may take the form of any of the embodiments discussed above with reference to the integrated circuit component 820.

The integrated circuit device assembly 800 illustrated in FIG. 8 includes a package-on-package structure 834 coupled to the second face 842 of the circuit board 802 by coupling components 828. The package-on-package structure 834 may include an integrated circuit component 826 and an integrated circuit component 832 coupled together by coupling components 830 such that the integrated circuit component 826 is disposed between the circuit board 802 and the integrated circuit component 832. The coupling components 828 and 830 may take the form of any of the embodiments of the coupling components 816 discussed above, and the integrated circuit components 826 and 832 may take the form of any of the embodiments of the integrated circuit component 820 discussed above. The package-on-package structure 834 may be configured in accordance with any of the package-on-package structures known in the art.

**FIG. 9** is a block diagram of an example electrical device 900 that may include one or more of the embodiments disclosed herein. For example, any suitable ones of the components of the electrical device 900 may include one or more integrated circuits with transistors having asymmetric source and drain contacts (e.g., transistor 100, IC 300), integrated circuit device assemblies 800, integrated circuit components 820, integrated circuit devices 600, or integrated circuit dies 502 disclosed herein. A number of components are illustrated in FIG. 9 as included in the electrical device 900, but any one or more of these components may be omitted or duplicated, as suitable for the application. In some embodiments, some or all of the components included in the electrical device 900 may be attached to one or more motherboards mainboards, or system boards. In some embodiments, one or more of these components are fabricated onto a single system-on-a-chip (SoC) die.

Additionally, in various embodiments, the electrical device 900 may not include one or more of the components illustrated in FIG. 9, but the electrical device 900 may include interface circuitry for coupling to the one or more components. For example, the electrical device 900 may not include a display device 906, but may include display device interface circuitry (e.g., a connector and driver circuitry) to which a display device 906 may be coupled. In another set of examples, the electrical device 900 may not include an audio input device 924 or an audio output device 908, but may include audio input or output device interface circuitry (e.g., connectors and supporting circuitry) to which an audio input device 924 or audio output device 908 may be coupled.

The electrical device 900 may include one or more processor units 902 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 900 may include a memory 904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 904 may include memory that is located on the same integrated circuit die as the processor unit 902. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 900 can comprise one or more processor units 902 that are heterogeneous or asymmetric to another processor unit 902 in the electrical device 900. There can be a variety of differences between the processing units 902 in a system in terms of a spectrum of metrics of merit including architectural, microarchitectural, thermal, power consumption characteristics, and the like. These differences can effectively manifest themselves as asymmetry and heterogeneity among the processor units 902 in the electrical device 900.

In some embodiments, the electrical device 900 may include a communication component 912 (e.g., one or more communication components). For example, the communication component 912 can manage wireless communications for the transfer of data to and from the electrical device 900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 912 may operate in accordance with other wireless protocols in other embodiments. The electrical device 900 may include an antenna 922 to facilitate wireless communications and/or to receive other wireless communications (such as AM or FM radio transmissions).

In some embodiments, the communication component 912 may manage wired communications, such as electrical, optical, or any other suitable communication protocols (e.g., IEEE 802.3 Ethernet standards). As noted above, the communication component 912 may include multiple communication components. For instance, a first communication component 912 may be dedicated to shorter-range wireless communications such as Wi-Fi or Bluetooth, and a second communication component 912 may be dedicated to longer-range wireless communications such as global positioning system (GPS), EDGE, GPRS, CDMA, WiMAX, LTE, EV-DO, or others. In some embodiments, a first communication component 912 may be dedicated to wireless communications, and a second communication component 912 may be dedicated to wired communications.

The electrical device 900 may include battery/power circuitry 914. The battery/power circuitry 914 may include one or more energy storage devices (e.g., batteries or capacitors) and/or circuitry for coupling components of the electrical device 900 to an energy source separate from the electrical device 900 (e.g., AC line power).

The electrical device 900 may include a display device 906 (or corresponding interface circuitry, as discussed above). The display device 906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 900 may include an audio output device 908 (or corresponding interface circuitry, as discussed above). The audio output device 908 may include any embedded or wired or wirelessly connected external device that generates an audible indicator, such speakers, headsets, or earbuds.

The electrical device 900 may include an audio input device 924 (or corresponding interface circuitry, as discussed above). The audio input device 924 may include any embedded or wired or wirelessly connected device that generates a signal representative of a sound, such as microphones, microphone arrays, or digital instruments (e.g., instruments having a musical instrument digital interface (MIDI) output). The electrical device 900 may include a Global Navigation Satellite System (GNSS) device 918 (or corresponding interface circuitry, as discussed above), such as a Global Positioning System (GPS) device. The GNSS device 918 may be in communication with a satellite-based system and may determine a geolocation of the electrical device 900 based on information received from one or more GNSS satellites, as known in the art.

The electrical device 900 may include other output device(s) 910 (or corresponding interface circuitry, as discussed above). Examples of the other output device(s) 910 may include an audio codec, a video codec, a printer, a wired or wireless transmitter for providing information to other devices, or an additional storage device.

The electrical device 900 may include other input device(s) 920 (or corresponding interface circuitry, as discussed above). Examples of the other input device(s) 920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 900 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a display device (e.g., monitor, television), a set-top box, an entertainment control unit, a video game console, a video playback device, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 900 may be any other electronic device that processes data. In some embodiments, the electrical device 900 may comprise multiple discrete physical components. Given the range of devices that the electrical device 900 can be manifested as in various embodiments, in some embodiments, the electrical device 900 can be referred to as a computing device or a computing system.

While the concepts of the present disclosure are susceptible to various modifications and alternative forms, specific embodiments thereof have been shown by way of example in the drawings and are described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features. Further, it should be understood that the various embodiments shown in the figures are illustrative representations and are not necessarily drawn to scale.

Moreover, the illustrations and/or descriptions of various embodiments may be simplified or approximated for ease of understanding, and as a result, they may not necessarily reflect the level of precision nor variation that may be present in actual embodiments. For example, while some figures generally indicate straight lines, right angles, and smooth surfaces, actual implementations of the disclosed embodiments may have less than perfect straight lines and right angles, and some features may have surface topography or otherwise be non-smooth, given real-world limitations of fabrication processes. Similarly, illustrations and/or descriptions of how components are arranged may be simplified or approximated for ease of understanding and may vary by some margin of error in actual embodiments (e.g., due to fabrication processes, etc.).

Unless otherwise specified, the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

The terms "substantially," "close," "approximately," "near," and "about," generally refer to being within +/- 10% of a target value (unless otherwise specified). Similarly, terms describing spatial relationships, such as "perpendicular," "orthogonal," or "coplanar," may refer to being substantially within the described spatial relationships (e.g., within +/- 10 degrees of orthogonality).

Certain terminology may also be used in the foregoing description for the purpose of reference only, and thus are not intended to be limiting. For example, terms such as "upper," "lower," "above," "below," "bottom," and "top" refer to directions in the drawings to which reference is made. Terms such as "front," "back," "rear," and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

The terms "over", "under", "between", "adjacent", "to", and "on" as used herein may refer to a relative position of one layer or component with respect to other layers or components. For example, one layer "over", "under", or "on" another layer, "adjacent" to another layer, or bonded "to" another layer may be directly in contact with the other layer or may have one or more intervening layers. One layer "between" layers may be directly in contact with the layers or may have one or more intervening layers.

The meaning of "a," "an," and "the" include plural references. The meaning of "in" includes "in" and "on."

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views.

The term "package" generally refers to a self-contained carrier of one or more dice, where the dice are attached to or embedded in the package substrate, and may be encapsulated for protection, with integrated or wire-bonded interconnects between the dice, along with leads, pins, or bumps located on the external portions of the package substrate. The package may contain a single die, or multiple dice, providing respective functions. The package may be mounted on a printed circuit board for interconnection with other packaged integrated circuits and discrete components, forming a larger circuit.

The term "cored" generally refers to a substrate of an integrated circuit package built upon a board, card, or wafer comprising a non-flexible stiff material. Typically, a small printed circuit board is used as a core, upon which integrated circuit device and discrete passive components may be soldered. Typically, the core has vias extending from one side to the other, allowing circuitry on one side of the core to be coupled directly to circuitry on the opposite side of the core. The core may also serve as a platform for building up layers of conductors and dielectric materials.

The term "coreless" generally refers to a substrate of an integrated circuit package having no core. The lack of a core may allow for higher-density package architectures, as the through-vias may have relatively large dimensions and pitch compared to high-density interconnects.

The term "land side" generally refers to the side of the substrate of the integrated circuit package closest to the plane of attachment to a printed circuit board, motherboard, or other package. This is in contrast to the term "die side", which generally refers to the side of the substrate of the integrated circuit package to which the die or dice are attached.

The terms "dielectric" and "dielectric material" generally refer to any type or number of non-electrically conductive materials. In some cases, dielectric material may be used to make up the structure of a package substrate. For example, dielectric material may be incorporated into an integrated circuit package as layers of laminate film or as a resin molded over integrated circuit dice mounted on the substrate.

The term "metallization" generally refers to metal layers formed on, over, and/or through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and may carry the same or similar meaning.

The term "bump" generally refers to a conductive layer or structure formed on a bond pad, which is typically made of solder or metal and has a round or curved shape, hence the term "bump".

The term "substrate" generally refers to a planar platform that may include dielectric, metallization, and/or semiconductor device structures. For example, a substrate may be or may contain an integrated circuit die or may be used to fabricate an integrated circuit die. As another example, a substrate may mechanically support and electrically couple one or more IC dies on a single platform, with encapsulation of the one or more IC dies by a moldable dielectric material. A substrate may include bumps or pads as bonding interconnects on one or both sides. For example, one side of the substrate, generally referred to as the "die side", may include bumps or pads for chip or die bonding. The opposite side of the substrate, generally referred to as the "land side", may include bumps or pads for bonding the package to a printed circuit board.

The term "assembly" generally refers to a grouping of parts into a single functional unit. For example, certain parts may be permanently bonded together, integrated together, and/or mechanically assembled (e.g., where parts may be removable) into a functional unit.

The terms "coupled" or "connected" means a direct or indirect connection, such as a direct electrical, mechanical, magnetic, or fluidic connection between the things that are connected or an indirect connection, through one or more passive or active intermediary devices.

The term "circuit" or "module" may refer to one or more passive and/or active components that are arranged to cooperate with one another to provide a desired function. The term "signal" may refer to at least one current signal, voltage signal, magnetic signal, or data/clock signal.

### Examples

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes a semiconductor device, comprising: a source and a drain; a source contact and a drain contact, wherein the source contact is coupled to the source and the drain contact is coupled to the drain, and wherein the source contact and the drain contact are asymmetric; a channel, wherein the source and the drain are coupled via the channel; and a gate, wherein the gate is coupled to the channel.

Example 2 includes the semiconductor device of Example 1, wherein one of the source contact or the drain contact is wider (wider contact) than the other of the source contact or the drain contact (narrower contact).

Example 3 includes the semiconductor device of Example 2, wherein the wider contact is at least 2 nanometers wider than the narrower contact.

Example 4 includes the semiconductor device of any of Examples 2-3, wherein the wider contact is at least 10% wider than the narrower contact.

Example 5 includes the semiconductor device of any of Examples 2-4, wherein the wider contact has a greater contact area than the narrower contact.

Example 6 includes the semiconductor device of any of Examples 2-5, wherein the narrower contact and the gate are on a frontside of the semiconductor device, and wherein the wider contact is on a backside of the semiconductor device.

Example 7 includes the semiconductor device of Example 6, wherein the narrower contact is coupled to a frontside interconnect, and wherein the wider contact is coupled to a backside interconnect.

Example 8 includes the semiconductor device of any of Examples 2-7, wherein the source contact is the wider contact and the drain contact is the narrower contact.

Example 9 includes the semiconductor device of any of Examples 2-7, wherein the drain contact is the wider contact and the source contact is the narrower contact.

Example 10 includes the semiconductor device of any of Examples 1-9, further comprising a transistor, wherein the transistor comprises the source, the drain, the source contact, the drain contact, the channel, and the gate.

Example 11 includes the semiconductor device of Example 10, wherein the transistor is a nanoribbon transistor, a gate-all-around (GAA) transistor, a fin field-effect transistor (FinFET), a planar transistor, or a two-dimensional transistor.

Example 12 includes an electronic device, comprising: one or more transistors, wherein individual transistors comprise: a source and a drain; a source contact and a drain contact, wherein the source contact is coupled to the source and the drain contact is coupled to the drain, and wherein one of the source contact or the drain contact is wider (wider contact) than the other of the source contact or the drain contact (narrower contact); a channel, wherein the source and the drain are coupled via the channel; and a gate, wherein the gate is coupled to the channel.

Example 13 includes the electronic device of Example 12, wherein the wider contact is at least 4 nanometers wider than the narrower contact.

Example 14 includes the electronic device of any of Examples 12-13, wherein the wider contact has a greater contact area than the narrower contact.

Example 15 includes the electronic device of any of Examples 12-14, wherein the narrower contact is above one of the source or the drain, and wherein the wider contact is below the other of the source or the drain.

Example 16 includes the electronic device of any of Examples 12-15, wherein: the source contact is the wider contact and the drain contact is the narrower contact; or the drain contact is the wider contact and the source contact is the narrower contact.

Example 17 includes the electronic device of any of Examples 12-16, further comprising: a circuit board; and an integrated circuit coupled to the circuit board, wherein the integrated circuit comprises processing circuitry, memory circuitry, storage circuitry, or communication circuitry, wherein one or more of the transistors are comprised in the processing circuitry, the memory circuitry, the storage circuitry, or the communication circuitry.

Example 18 includes a method, comprising: receiving a substrate; forming a channel over the substrate; forming a source and a drain over the substrate, wherein the source and the drain are coupled via the channel; forming a gate over the substrate, wherein the gate is coupled to the channel; and forming a source contact and a drain contact, wherein the source contact is coupled to the source and the drain contact is coupled to the drain, and wherein the source contact and the drain contact are asymmetric.

Example 19 includes the method of Example 18, wherein one of the source contact or the drain contact is wider (wider contact) than the other of the source contact or the drain contact (narrower contact).

Example 20 includes the method of Example 19, wherein the wider contact is below the substrate, and wherein the narrower contact and the gate are above the substrate.

## Claims

1. A semiconductor device, comprising:
a source and a drain;
a source contact and a drain contact, wherein the source contact is coupled to the source and the drain contact is coupled to the drain, and wherein the source contact and the drain contact are asymmetric;
a channel, wherein the source and the drain are coupled via the channel; and
a gate, wherein the gate is coupled to the channel.

2. The semiconductor device of Claim 1, wherein one of the source contact or the drain contact is wider (wider contact) than the other of the source contact or the drain contact (narrower contact).

3. The semiconductor device of Claim 2, wherein the wider contact is at least 2 nanometers wider than the narrower contact.

4. The semiconductor device of any one of Claims 2-3, wherein the wider contact is at least 10% wider than the narrower contact.

5. The semiconductor device of any one of Claims 2-4, wherein the wider contact has a greater contact area than the narrower contact.

6. The semiconductor device of any one of Claims 2-5, wherein the narrower contact is above one of the source or the drain, and wherein the wider contact is below the other of the source or the drain.

7. The semiconductor device of any one of Claims 2-6, wherein the narrower contact and the gate are on a frontside of the semiconductor device, and wherein the wider contact is on a backside of the semiconductor device.

8. The semiconductor device of Claim 7, wherein the narrower contact is coupled to a frontside interconnect, and wherein the wider contact is coupled to a backside interconnect.

9. The semiconductor device of any one of Claims 2-8, wherein the source contact is the wider contact and the drain contact is the narrower contact.

10. The semiconductor device of any one of Claims 2-8, wherein the drain contact is the wider contact and the source contact is the narrower contact.

11. The semiconductor device of any one of Claims 1-10, further comprising a transistor, wherein the transistor comprises the source, the drain, the source contact, the drain contact, the channel, and the gate.

12. The semiconductor device of Claim 11, wherein the transistor is a nanoribbon transistor, a gate-all-around (GAA) transistor, a fin field-effect transistor (FinFET), a planar transistor, or a two-dimensional transistor.

13. The semiconductor device of any one of Claims 11-12, further comprising:
a circuit board; and
an integrated circuit coupled to the circuit board, wherein the integrated circuit comprises processing circuitry, memory circuitry, storage circuitry, or communication circuitry, wherein the transistor is comprised in the processing circuitry, the memory circuitry, the storage circuitry, or the communication circuitry.

14. A method of forming the semiconductor device as claimed in any preceding claim.

15. At least one machine-accessible storage medium having instructions stored thereon, wherein the instructions, when executed on a machine, cause the machine to perform a method or realize an apparatus as claimed in any preceding claim.
